Europäisches Patentamt

(19) European Patent Office

Office européen des brevets

(11) **EP 0 718 888 A2**

(12) **EUROPEAN PATENT APPLICATION**

(43) Date of publication:
26.06.1996 Bulletin 1996/26

(51) Int. Cl.$^6$: **H01L 27/105**, H01L 21/8239

(21) Application number: 95308841.6

(22) Date of filing: 06.12.1995

(84) Designated Contracting States:
DE FR GB

(30) Priority: 22.12.1994 US 362382

(71) Applicant: AT&T Corp.
New York, NY 10013-2412 (US)

(72) Inventors:
• Colbry, Brian Wayne
Frenchtown, New Jersey 08825 (US)

• Gupta, Arupratan
Allentown, Pennsylvania 18103 (US)

(74) Representative: Watts, Christopher Malcolm
Kelway, Dr. et al
AT&T (UK) Ltd.
5, Mornington Road
Woodford Green Essex, IG8 0TU (GB)

(54) **Method for integrating analog and digital functional components, and resulting semiconductor chip including an integrated DRAM**

(57) Fabrication of a processing device and analog and digital components on a semiconductor chip may be performed simultaneously during the integration of a DRAM on the same chip by selectively applying the materials utilized in the integration of the DRAM and other desired materials onto the chip. The interconnections which may be fabricated during the simultaneous fabrication of these components on the chip provide improved data transfer capabilities on the chip and access to data that may be stored in the DRAM. The integration of multiple components together with a DRAM on a chip, furthermore, provides for the reduction of production and testing costs of a DRAM integrated on a semiconductor chip.

FIG. 2

EP 0 718 888 A2

## Description

### Field of the Invention

This invention relates generally to dynamic random access memory (DRAM) fabrication techniques. More particularly, the present invention relates to the use of DRAM fabrication techniques for simultaneously integrating analog and digital functional components on a semiconductor chip during the fabrication of a DRAM on the same chip.

### Background of the Invention

DRAM serves as a memory store in devices such as voice pagers, personal communicators and answering machines. A DRAM may be integrated in a region of a semiconductor chip by use of the well known masking, etching and photolithography techniques described in V. Rideout, "One-Device Cells for Dynamic Random-Access Memories: A Tutorial," IEEE Transactions on Electron Devices, vol. ED-26, no. 6, June 1979 pp. 839-52.

The integration of a DRAM on a semiconductor chip, however, does not always yield a DRAM having memory cells which are completely error-free, in other words, a DRAM having only non-faulty memory cells. Automatic test equipment (ATE) is typically used for testing for the presence of errors in the memory cells in the DRAM at varying levels of precision using well known techniques.

Typically, testing of DRAM memory cells is performed at the minimum level of precision required for determining whether the DRAM has sufficient non-faulty memory for use in a specific application. A DRAM tested at a low level of precision and found to have too much faulty memory for use in one memory storage application, such as data storage in personal computers, however, may be useful in another application, such as the storage of voice information in an answering machine, depending upon the actual number of non-faulty memory cells in the DRAM. A DRAM designated as a faulty DRAM according to one test criteria, therefore, must be redundantly re-screened for a more accurate determination of the percentage of memory which is non-faulty to determine whether alternative uses requiring less non-faulty memory are possible.

The cost of fabricating a device that uses a faulty DRAM is related to the total time expended in testing that particular DRAM. DRAM testing time is a function of the number of interfacing data, address and control bus lines which are used for performing data transfer between the integrated DRAM and the test apparatus, and the number of test vectors required for performing the necessary tests.

The high costs involved in manufacturing and testing a large pinout DRAM chip package having a large number of interfacing bus lines, however, place a practical limitation on the number of interfacing bus lines which are typically fabricated. This limitation, in turn, reduces the speed that a test apparatus, such as an ATE, can test a DRAM. The redundancy in the procedure for testing a faulty DRAM also contributes greatly to the production cost of the DRAM.

The integration of a digital processing device, such as a digital signal processor (DSP), on the same chip as the DRAM in order to increase DRAM testing speed has not previously been practical using present digital processing techniques. First, fabrication of a DSP on a chip in accordance with present DRAM processing techniques requires more chip area and increases the path length of connections within the DSP as compared to that typical for a DSP formed from two layers of metal using digital techniques. In addition, transistors fabricated using the materials associated with DRAM processing, if used in a DSP, would cause the DSP to operate at speeds that are less than those attainable by transistors formed according to digital processing techniques. Longer path lengths also result in increased path delays that, in turn, would cause a DSP to operate at a slower speed. Moreover, a DSP that can operate only at a relatively slow speed will not be able to process data, such as speech information, using the complex compression algorithms typically used for compressing data prior to storage in a DRAM, thereby necessitating a larger and more costly DRAM to be used for purposes of storing data.

### Summary of the Invention

In accordance with the present invention, analog and digital functional components and interfacing connections between these components may be fabricated on a semiconductor chip simultaneously during the integration of a DRAM on the same chip. These components and interfacing connections may be fabricated on a single chip by the selective application on different regions of the chip or a first metal layer and first and second polysilicon layers which are ordinarily used to fabricate the DRAM and, in addition, the selective diffusion of impurities having different conductivities and the selective application of an additional, second metal layer also on the same chip.

In a first embodiment, the second metal layer may be selectively applied on the chip to create an interfacing bus line that connects components in a DRAM, which is fabricated in one region of the chip, to other components that may be fabricated in other regions of the chip. The fabrication of a plurality of these interfacing bus lines between the DRAM and a DSP, which may be fabricated using high conductivity materials diffused on another region of the chip, enables the DSP to read from and write to the memory cells in the DRAM for testing the memory cells in the DRAM at high speeds. In addition, the integration of the DSP on the same chip as the DRAM enables the DSP to use a portion of the DRAM as a scratch pad memory for processing data written to and read from the DRAM.

In a further aspect of the invention, a resistive structure having high resistivity characteristics, and hence small physical area requirements, may be fabricated on a portion of the chip during DRAM integration by the selective application of the first polysilicon layer.

In another aspect of the invention, a capacitive structure may be fabricated on the chip by the selective application of the second polysilicon layer to form second capacitive plates that overlay first capacitive plates which are formed by the selective application of the first polysilicon layer. The capacitive structure formed in accordance with the present invention may further include the first metal layer which is selectively applied on the chip for interconnecting a pair of second capacitive plates, and the second metal layer which is selectively applied on the chip for interconnecting a pair of first capacitive plates which underlie the pair of second capacitive plates interconnected by the selectively applied first metal layer.

Simultaneous fabrication of a DSP and resistive and capacitive structures on the same chip during DRAM integration may provide for a single chip solution for high speed data processing and memory storage applications.

Further features and advantages of the present invention will be readily apparent from the detailed description that follows.

## Description of the Drawings

FIG. 1 illustrates a block diagram layout of functional components that may be fabricated on a semiconductor chip which includes a DRAM according to the present invention.

FIG. 2 illustrates a circuit including an interfacing connection between a circuit element in a DRAM and a circuit element in a DSP which may be fabricated on the chip shown in FIG. 1 according to the present invention.

FIG. 3A illustrates a three-dimensional cross-sectional view of an exemplary arrangement of components on the chip shown in FIG. 1 which are illustrated in FIG. 2.

FIG. 3B is a flow diagram for the fabrication of an interconnection according to the present invention between the DRAM and the DSP as illustrated in FIG. 2.

FIGS. 4A-4S are cross-sectional views of the components illustrated in FIG. 2 in various stages of fabrication thereof according to the steps of the flow diagram in FIG. 3B.

FIG. 4T is a three-dimensional cross-sectional view of the interconnection between the DSP and the DRAM region of the chip in FIG. 1 as illustrated in FIG. 2.

FIG. 5A illustrates a resistive structure which may be fabricated on a semiconductor chip according to the present invention.

FIG. 5B is a flow diagram for the fabrication of a resistive structure on a semiconductor chip during DRAM integration according to the present invention.

FIGS. 5C-5F are cross-sectional views of the fabrication of the resistive structure as shown in FIG. 5A in various stages of fabrication thereof on a region of the chip shown in FIG. 1.

FIG. 5G illustrates a top view of an exemplary layout of a resistive structure fabricated according to the present invention.

FIG. 6A illustrates a capacitive structure which may be fabricated on a region of a semiconductor chip during DRAM integration according the present invention.

FIG. 6B is a flow diagram illustrating the fabrication of the capacitive structure shown in FIG. 6A on the chip shown in FIG. 1 during DRAM integration according to the present invention.

FIGS. 6C-6J are cross-sectional views of the fabrication of the capacitive structure shown in FIG. 6A in various stages of fabrication thereof according to the present invention.

FIG. 6K is a three-dimensional cross-sectional view of the region of the chip shown in FIG. 1 which illustrates the capacitive structure shown in FIG. 6A fabricated according to the steps shown in FIG. 6L.

FIG. 6L illustrates the connections between the polysilicon and metal layers which may be fabricated according to the present invention to create the capacitive structure shown in FIG. 6A.

## Detailed Description

The materials and processing techniques for integrating a DRAM on a semiconductor chip may simultaneously be used for fabricating on the same chip, or DRAM chip, other analog and digital functional components as well as interconnections between or among these components and between each of these components and the DRAM.

The interconnections to the DRAM which may be created according to the present invention may be used, for instance, for establishing interfaces between the DRAM and circuit elements of a processor, such as a digital signal processor (DSP), which may also be integrated on the DRAM chip. As explained below, the fabrication of interfaces between the DRAM and the DSP on the same chip permits DSP testing of the memory cells of the DRAM in a highly advantageous manner. Further, capacitive and resistive structures may be fabricated on other regions of the DRAM chip during the DRAM integration to create analog and digital components which may be advantageously used in signal processing applications that favor the use of a single chip including a DSP and a DRAM.

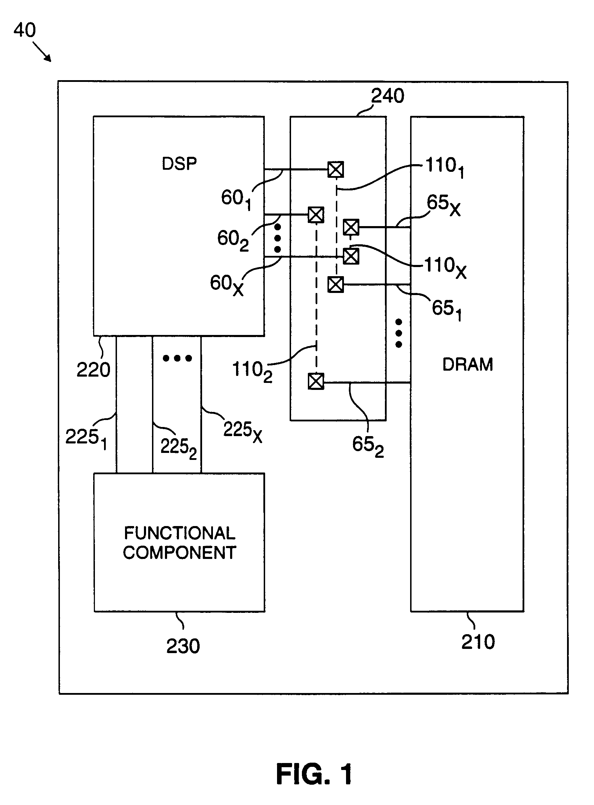

FIG. 1 illustrates, in block diagram form, the components and interconnections that may be fabricated on an exemplary semiconductor chip 40 according to the present invention. For purposes of illustration, the chip 40 comprises a DRAM 210 which is connected to a digital signal processor (DSP) 220 via a metal routing region 240 in the manner explained below. The DSP 220 is exemplary of any presently known or subsequently developed digital signal processing device.

The chip 40 further includes an integrated functional component 230 which is connected to the DSP 220 as explained below. The component 230 may be implemented as either an analog or digital device which is fabricated simultaneously on the chip 40 during DRAM processing.

In a first embodiment, the present invention is described with respect to the fabrication of a plurality of interfacing interconnections $110_{1,2...x}$ between the DSP 220 and the DRAM 210. As explained in further detail below, the number of interconnections, x, which is formed between the DSP 220 and the DRAM 210, is preferably equal to the minimum number required for interfacing the DSP 220 to the DRAM 210, such that the DSP 220 may test the DRAM 210 at the maximum processing capability or speed of the DSP 220. It is to be understood that the interfacing interconnections $110_{1,2...x}$ which are formed between the DSP 220 and the DRAM 210 are exemplary of the interconnections that may be formed for interfacing other components which may be fabricated on the chip 40 according to the present invention.

By way of example, the present invention is described below with reference to the use of a DRAM chip, which includes a DSP and other components which may be fabricated according to the inventive technique, for voice information processing and memory storage. It is to be understood that other components may be fabricated on a DRAM chip for other possible applications, such as, for example, memory storage in a microcomputer or a calculator, in accordance with the techniques of this invention.

Referring to FIG. 1, the interfacing interconnections $110_{1,2...x}$ between the DSP 220 and DRAM 210 are suitably fabricated in the metal routing region 240 which is located on the chip 40 between the DSP 220 and the DRAM 210. The metal routing region 240 is included on the chip 40 because alignment differences inherent to the DRAM and DSP integration processes and the large number of interconnections which would typically be desired to be fabricated for interfacing a DRAM to a DSP on the same chip do not ordinarily allow direct connections between circuit elements in the DRAM 210 and the DSP 220. The fabrication of a metal routing region 240 on the chip 40 for the purpose of overcoming alignment problems encountered during the integration of different components on a semiconductor chip is a well known technique, and described in detail in Y. Hsich & C.C. Chang, "A Modified Detour Router," ICCAD-85 Conference Proceedings, pp. 301-34 (1985), and J.R. Stenstrom & R.M. Mattheyes, "Switch-box Routing the Greedy Way," ICCAD-85 Conference Proceedings, pp. 307-09 (1985).

The plurality of interconnections $110_{1,2...x}$ fabricated on the chip 40 to connect the DSP 220 to the DRAM 210 are described below, by way of example, with respect to the use of these interconnections for connecting, respectfully, a plurality of DSP signal stubs $60_{1,2...x}$ leading from the DSP 220 to a plurality of DRAM signal stubs $65_{1,2...x}$ which extend from the DRAM 210, as representatively shown in FIG. 1. The interconnections $110_{1,2...x}$ may comprise the control, data and address bus line connections that would typically be used for interfacing the DSP 220 to the DRAM 210 for data transfer and DRAM memory cell testing purposes.

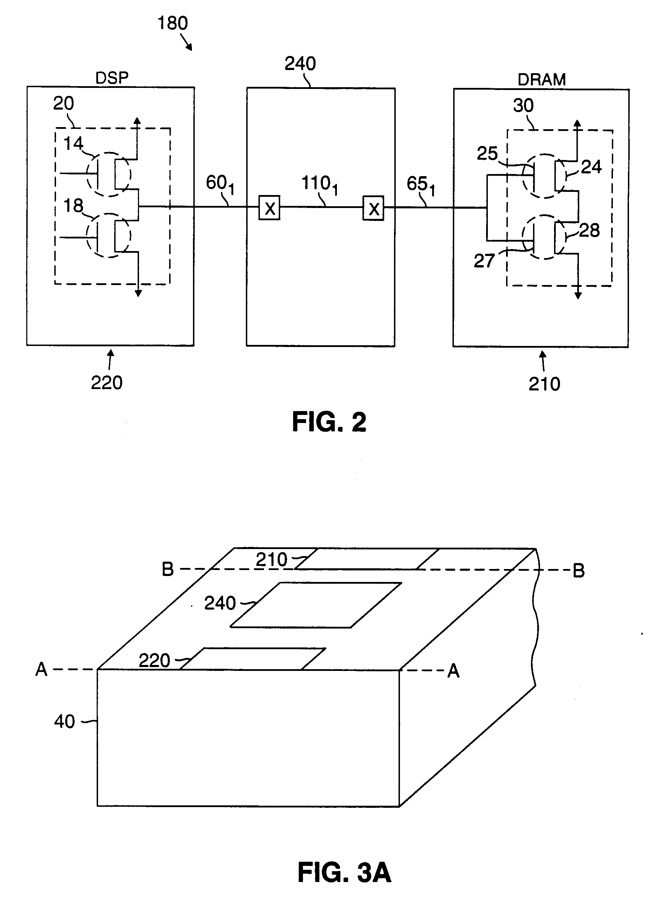

FIG. 2 shows an exemplary circuit 180 which is described below to illustrate the fabrication of the interconnection $110_1$ according to the present invention as an address bus line between the DSP 220 and the DRAM 210. The circuit 180 comprises a DSP output driver 20, which is comprised of high conductivity transistors 14 and 18, and a DRAM address decoder 30, which is comprised of low conductivity transistors 24 and 28. The circuit 180 further comprises the DSP signal stub $60_1$, the DRAM signal stub $65_1$ and the interconnect $110_1$.

The components in the circuit 180 are connected in the following manner. The DSP signal stub $60_1$ is connected to the drain of the transistor 14 and the source of the transistor 18. The DRAM signal stub $65_1$ is connected to gates 25 and 27 of the transistors 24 and 28, respectively. Further, the drain of the transistor 24 is connected to the source of the transistor 28. The interconnect $110_1$ connects the DSP signal stub $60_1$ to the DRAM signal stub $65_1$.

FIG. 3A shows a three-dimensional cross-sectional view of the DRAM 210, the DSP 220 and the routing region 240 as they may be integrated onto the chip 40 according to the present invention. The cross-sectional lines AA and BB indicated on FIG. 3A are used below as reference lines for referring to the fabrication of the elements contained in the circuit 180 which are described above on different regions of the chip 40. The lines AA and BB, respectively, correspond to the integrated DSP 220 and DRAM 210 regions of the chip 40.

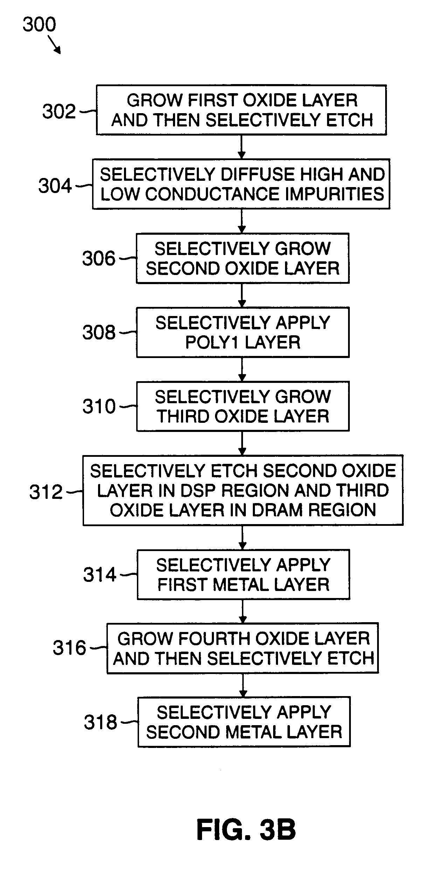

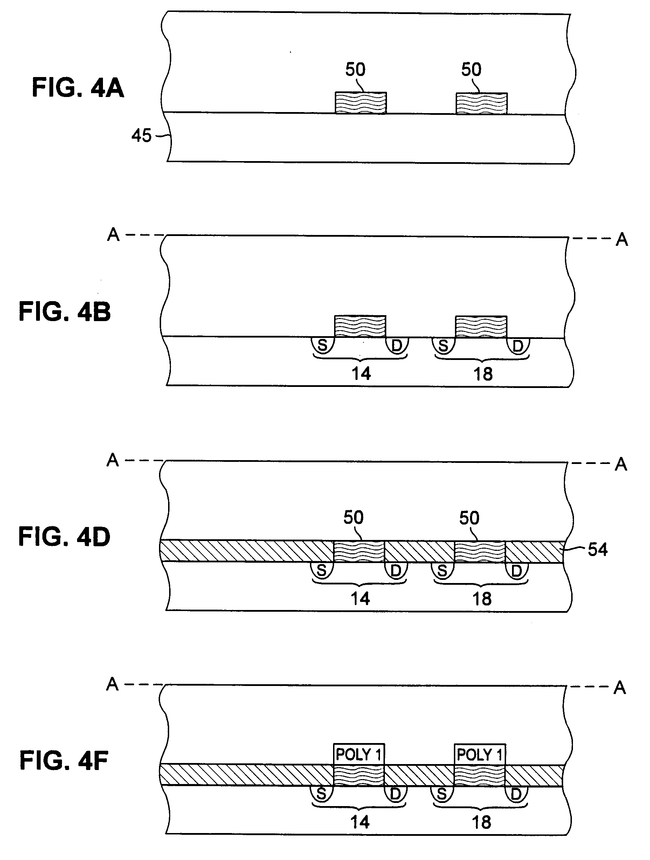

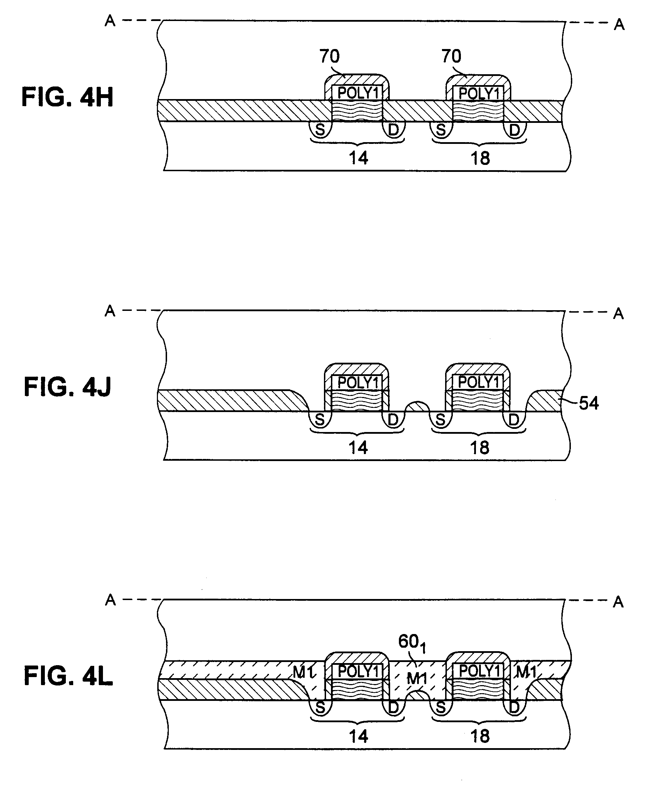

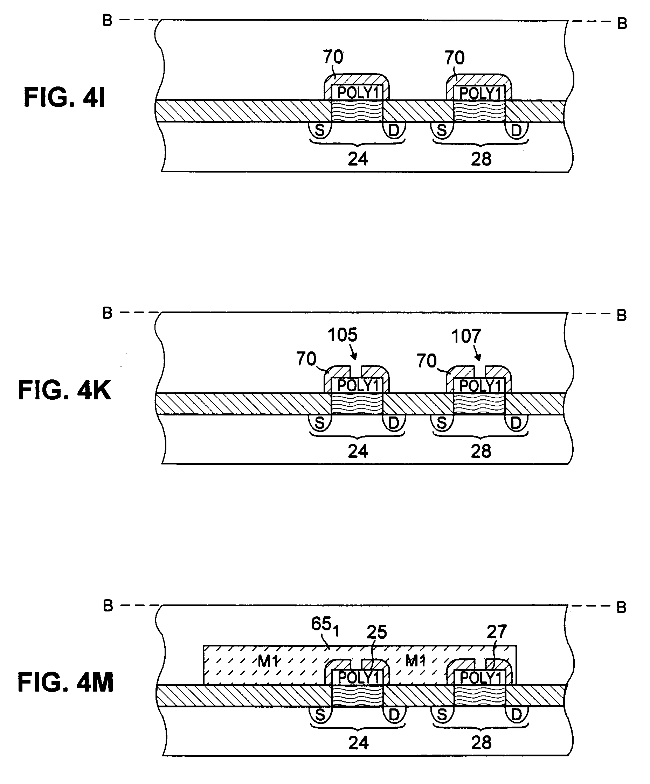

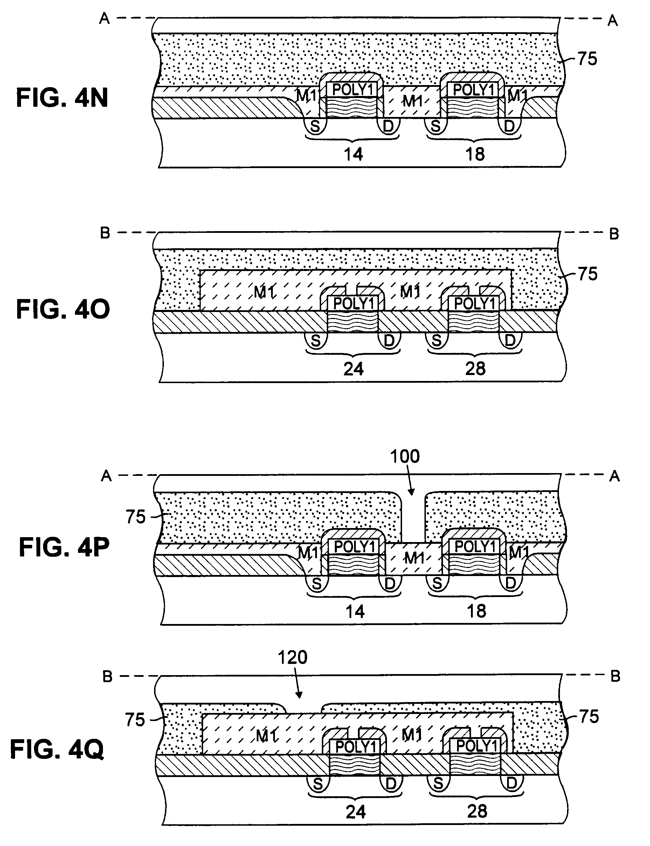

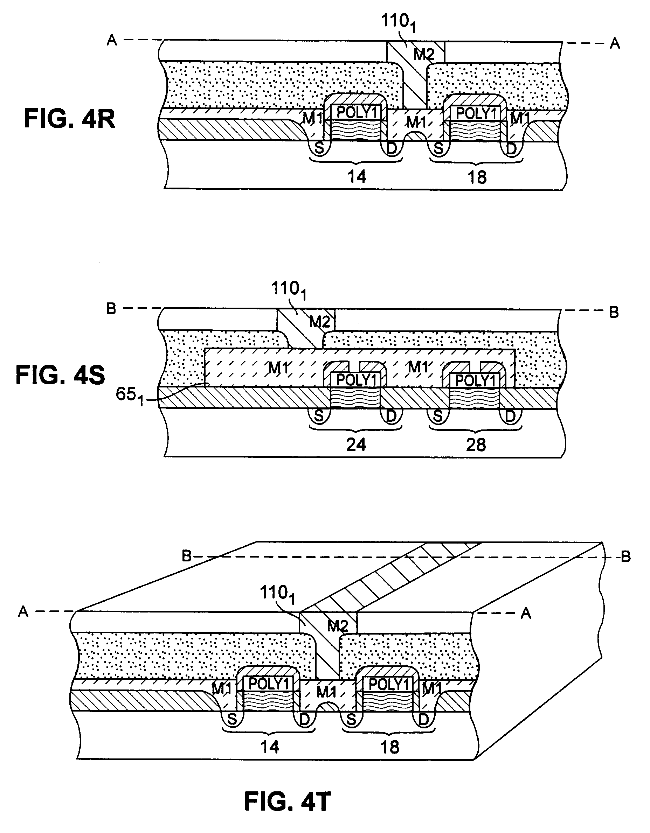

The methodologies typically involved in the fabrication of the circuit elements which are included in the integrated DSP 220 and DRAM 210 are well known. The fabrication of the circuit elements in the circuit 180, such as the DSP output driver 20 and the DRAM address decoder 30, is therefore described in detail below with reference to a process 300, shown in FIG. 3B, only with respect to those steps of DRAM fabrication which are necessary for describing the formation of the interconnection $110_1$ and high conductivity transistors 14 and 18 in the DSP 220. Cross-sectional views of the chip 40 during fabrication pursuant to the steps of the process 300 are shown in FIGS. 4A-4S. The technique of interconnecting the DRAM 210 and DSP 220 during DRAM integration in accordance with this invention, and, in particular, fabricating a high speed DSP as the DSP 220, constitutes a substantial improvement over the prior art.

In step 302, a first layer of oxide 50 is grown on one surface of a semiconductor substrate 45, such as silicon, of the chip 40 and then selectively etched, as shown in FIG. 4A.

Then, in step 304, high conductivity impurities are selectively diffused in the AA region of the chip 40 to form the sources (S) and drains (D) of the transistors 14 and 18 of the DSP output driver 20, as shown in FIG. 4B.

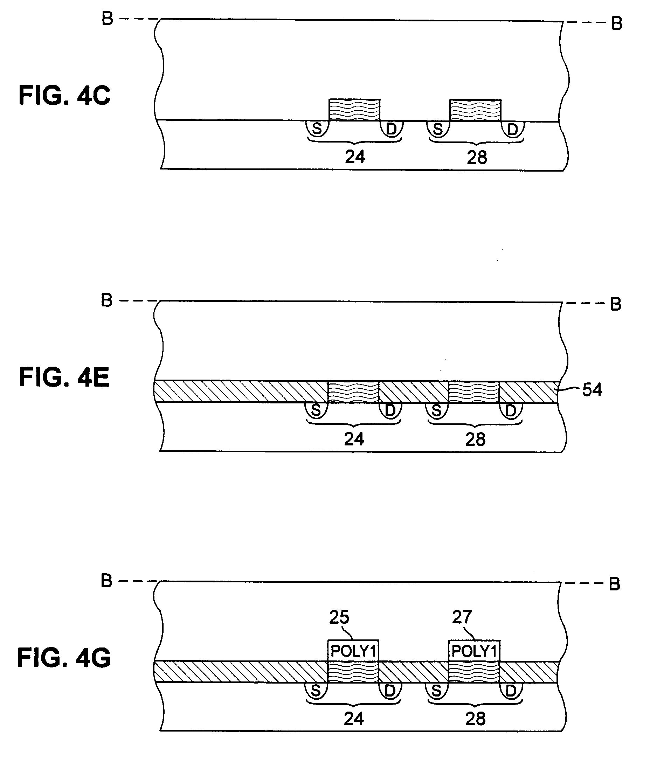

Simultaneously in step 304, low conductivity impurities are selectively diffused in the BB region of the chip 40 to form the sources and drains of the transistors 24 and 28 of the DRAM address decoder 30, as shown in FIG. 4C.

In step 306, a second oxide layer 54 is selectively grown on the entire chip, except on the remaining regions of the oxide 50, as shown in FIGS. 4D and 4E.

In step 308, a first layer of polysilicon POLY1 is then selectively applied on the chip 40 to form the gates of the transistors 14 and 18 and the gates 25 and 27 of the transistors 24 and 28, respectively, as shown in FIGS. 4F and 4G.

In step 310, a third oxide layer 70 is then grown on the chip 40 and selectively etched to insulate the gates of the transistors 14, 18, 24 and 28, as shown in FIGS. 4H and 4I.

Then, in step 312, the oxide layer 54 is selectively etched in the AA region of the chip 40 to expose portions of the sources and drains of the transistors 14 and 18, as shown in FIG. 4J. simultaneously, in step 312, in the BB region of the chip 40, the oxide layer 70 is selectively etched to create conductive vias 105 and 107 to the gates 25 and 27, as shown in FIG. 4K.

In step 314, a first layer of metal M1 is selectively applied in the line AA region of the chip 40 to form the DSP signal stub $60_1$. The signal stub $60_1$ creates a contact between the drain of the transistor 14 and the source of the transistor 18, as shown in FIG. 4L. Also in step 314, the M1 layer is simultaneously selectively applied in the line BB region of the chip 40 to form the DRAM signal stub $65_1$. As shown in FIG. 4M, the signal stub $65_1$ creates a contact between the gates 25 and 27 of the transistors 24 and 28, respectively, by way of the conductive vias 105 and 107.

In step 316, a fourth oxide layer 75 is then grown on the entire surface of the chip 40, as shown in FIGS. 4N and 4O, and then selectively etched to form a conductive via 100 to the DSP signal stub $60_1$, as shown in FIG. 4P, and a conductive via 120 to the DRAM signal stub $65_1$, as shown in FIG. 4Q.

Then, in step 318, a second layer of metal M2 is selectively applied as a strip that extends transversely on the chip 40 from the conductive via 100 in the line AA region of the chip 40 to the conductive via 120 in the line BB region of the chip 40. This strip forms the interconnect $110_1$ as shown in FIGS. 4R and 4S. FIG. 4T shows a three-dimensional cross-sectional view of the connection formed between the DRAM 210 and the DSP 220 regions on the chip 40 using the interconnection $110_1$.

The steps of the process 300 involving the selective deposition of the M2 layer for creating the high conductivity interconnect $110_1$, and for simultaneously creating low conductivity transistors 24 and 28 in the DRAM 210 and high conductivity transistors 14 and 18 in the DSP 220, exploit known DRAM processing techniques and provide a method for simultaneous integration and interfacing of the DRAM 210 to the DSP 220, as illustrated by the fabrication of the interconnection $110_1$ formed between the DRAM address decoder 30 to the DSP output driver 30 on the chip 40 described above. This processing technique is a significant improvement over the prior art because a standard DRAM process does not typically provide for the formation of high conductivity transistors on a semiconductor chip, and the use of present digital processing techniques, such as standard CMOS digital techniques, only provide for the fabrication of transistors having low conductivity.

Because the DSP 220 may be formed from high conductivity transistors which are interconnected to the DRAM 210, high speed testing of the DRAM 210 may be performed in a highly advantageous manner according to the present invention, as described in further detail below. A general description of the methodology for testing the memory cells in a DRAM is provided at this point to provide a background for explaining the advantages of using a DSP integrated on a DRAM chip according to the present invention for testing the DRAM at high speeds. The reader is directed to A. Greenberger and S. Homayoon, U.S. Patent No. 5355369, incorporated by reference herein, for a more detailed description of DRAM testing.

The memory region of a DRAM comprises memory cells which are arranged as rows and columns of a matrix. The matrix is typically subdivided for purposes of testing into a plurality of memory segments, where each memory segment is comprised of a plurality of memory bits. Each memory segment in the matrix is tested to obtain a profile of the location of faulty and non-faulty memory segments.

A memory segment will fail a test if the total number of bad memory bits anywhere in that segment exceeds a specific value, called the failure criteria. The failure criteria is related to the planned use of the DRAM which is being tested, and defines the maximum number of bad bits that may be present in a memory segment. A memory segment is called faulty if it has more bad bits than the amount specified by the failure criteria. When DRAM testing is performed, a memory segment found faulty is characterized in the profile as not being available for use in a planned DRAM application.

The total number of memory segments in a matrix which is designated as not faulty defines the amount of memory available for data storage for the planned DRAM application. The total available memory measured, therefore, determines whether the DRAM, as a whole, has a sufficient amount of memory for the planned application. Memory segment testing, in other words, ensures that data may be stored in a DRAM at a level of quality which is acceptable for the planned DRAM application.

By way of example, testing of a 4 megabit (MB) DRAM for use in audio data storage, such as a voice data storage component in an answering machine, would typically involve subdividing the matrix into 256 memory segments, where a memory segment is comprised of 16 kilobits (KBs). For voice storage, the failure criteria is typically that a memory segment having more than 64 bad bits is declared faulty. Because voice data is typically compressed using a standard voice compression algorithm from the typical rate of 64 KB/s to 4.3 KB/s prior to storage in a memory matrix, each 16 KB memory segment designated as faulty in a 4 MB DRAM decreases the total amount of memory deemed available in the DRAM by four seconds. For example, if all the bits of a 4 MB DRAM are non-faulty, the total voice storage capability would be equal to approximately 16 minutes using the above described voice compression scheme.

As noted above, the DRAM matrix profile indicates whether the DRAM has enough non-faulty memory for a specific application. Oftentimes, bad memory bits are grouped together in close proximity within the matrix, such that a large portion of a memory segment which is tested may in fact contain no bad memory bits. The number of memory segments that a matrix is subdivided into for purposes of testing, therefore, determines the precision with which bad memory bits are identified in the matrix.

Theoretically, a matrix may be tested at any level of precision for any of a variety of suitable DRAM applications. As is well known, a DRAM is tested at the lowest level of precision necessary for ensuring adequate memory storage for the planned DRAM application. As explained above, a 4MB DRAM will only be subdivided into 256 memory segments for testing for audio data storage applications. Subdividing a matrix into a number greater than the number of memory segments typically utilized for the planned DRAM application testing proportionally increases the processing time involved in DRAM testing, thereby significantly contributing to the cost of a DRAM chip.

Integrating a processor, such as a high speed digital signal processor on the same chip as the DRAM according to the present invention, on the other hand, allows high speed testing of the matrix of memory cells, so as to overcome the above testing time problem of cost associated with the use of a faulty DRAM in a device. Since the method of testing a DRAM is well known, only exemplary features of DRAM testing that are improved according to the present invention are described below.

For example, in the prior art, cost considerations involving DRAM chip size, and manufacturing and testing of a high pinout package, typically limited the number of interfacing connections for data transfer between the DRAM 210 and an off-chip testing apparatus, such as an ATE or a DSP integrated on a separate chip, hereinafter called an off-chip processor, to four data bus lines, twelve address bus lines and three control lines for a voice data storage DRAM planned application. This limitation on the number of possible interconnections required that the off-chip processor address the memory cells in the matrix and transfer data to and from these memory cells using the well known techniques of time multiplexing, which increased the time required for reading from and writing to the memory cells in the DRAM. For example, in time multiplexing, the off-chip processor addresses a memory cell location by first transmitting a row address and then a column address in time sequence order.

According to the present invention, the integration of the DSP 220 on the same chip 40 as the DRAM 210 allows for the formation of a suitable number of interfacing interconnections $110_{1,2...x}$, which may provide for the parallel connection of the DSP 220 to the address lines associated with the rows and columns of the matrix of memory cells in the DRAM 210. The number of interconnections, x, which should preferably be formed between the DRAM 210 and the DSP 220 on the same chip 40 may be calculated from the equation $x = n + k + j$, where n is equal to the number of data bus lines required for transferring data from the matrix and is a function of the width of a data word stored in the matrix; k is equal to the logarithm of the number of memory bits in the matrix divided by the logarithm of 2; and, j is equal to the number of control lines required for testing the DRAM. For example, a total of 43 interfacing connections should be fabricated on the chip 40, where 16 interfacing connections are used as data bus lines and 3 interfacing connections are used as control lines, to enable the DSP 220 to address 16 MBs of memory or four 4 MB DRAMs and store 60 minutes of voice data therein at current voice compression rates.

The capability of fabricating any number of interfacing connections on the chip 40, as calculated according to the equation set forth above, permits the DSP 220 to access an entire row of memory cells at a time in the DRAM 210 matrix. The technique of accessing an entire row of memory cells in a matrix at a time is called fast page access. According to the present invention, fast page access may be performed because multiple bits may be simultaneously accessed from the DRAM 210 matrix one row at a time by the DSP 220 over the required number of address and data bus lines which may be integrated on the chip 40.

The ability of the DSP 220 to access an entire row of memory bits for processing using the available interfacing connections, in turn, increases the speed that the memory cells of the DRAM 210 may be tested. The DRAM 210, therefore, may be tested more precisely and for many possible applications in a reduced amount of time and solely based on the performance of one test by the DSP 220. In this manner, various grades of DRAM memory storage products may be automatically categorized by a DSP fabricated on the same DRAM chip, thereby dramatically reducing testing time and, in turn, reducing the cost of the product which incorporates the faulty DRAM chip.

The integration of the DRAM 210 and the DSP 220 on the same chip 40 further provides the advantage that the DSP 220 may use part of the DRAM 210 as a scratch pad memory. As is well known, a scratch pad memory typically is comprised of a static random access memory (SRAM) or buffer memory region which is utilized by a processor for temporary storage of data during the processing of data read to and written from the DRAM. For example, a DSP may use a scratch pad when processing frames of voice data for storage in a DRAM incorporated in an answering machine. In the prior art, an off-chip processor, such as a DSP integrated on a separate chip, always included a SRAM.

According to the present invention, a portion of the DRAM 210 may be used as a scratch pad memory for processing data which may be written to and read from the DRAM 210 by the DSP 220, because of the limitless number of interfacing bus lines which may be fabricated between the DRAM 210 and the DSP 220 and because an entire row of data in the DRAM 210 may be accessed by the DSP 220 at high speeds which allow the use of fast page access. Integrating the DSP 220 and the DRAM 210 on the same chip 40, therefore, eliminates the need for an additional SRAM, thereby reducing the cost of memory storage and data processing chips in a device including a DRAM chip. For instance, when a 1 to 2 MB DRAM is integrated on the same chip as a DSP, 16 KB of the DRAM may be utilized as a scratch pad in place of a separate SRAM without affecting the quality of voice information memory storage.

Furthermore, if a larger memory is required for other processing applications, the total required chip area for memory storage may be reduced because of the approximate eight to one density ratio of SRAM memory cell area to DRAM memory cell area. Therefore, the DSP 220, which is fabricated on the chip 40 according to the present invention, may consume less chip area than if it was fabricated on a separate chip which may be included together with a DRAM chip in a particular device. This lower chip area requirement, in turn, lowers the cost of the chip that may be utilized in a data processing and memory storage system, such as, for example, a voice storage system which uses a chip incorporating a DRAM and a DSP.

In addition, because off-chip communication and data transfer between an off-chip processor and a DRAM in the prior art occurred at a rate which was less than the maximum rated capacity of the off-chip processor, the off-chip processor in most circumstances could not perform instructions of an algorithm for processing data at the speed required for suitable data compression. For example, the complex compression algorithms typically utilized for voice compression could not be performed at the required, rated speed of the processor because data could not be transferred to and from the DRAM matrix at that same rated speed. In these circumstances, a time delay, known as a wait state, was typically included as a step in the algorithm to compensate for the difference between the slower data transfer rate and the rated speed of the off-chip processor. The utilization of one or more wait states increased the time required for transferring data to and accessing data from the DRAM, thereby increasing the cost of testing the DRAM.

For example, in well known prior art techniques involving data transmission between an off-chip processor and a DRAM for purposes of voice information memory storage, the transmission of sixteen bits of data over four data bus lines typically required that a 33 MHz off-chip processor access the DRAM four times, where each access typically took 70 to 160 ns, because the number of row and column address lines available for off-chip DRAM testing was approximately equal to four, as explained above. Therefore, the typical 33 mega instructions processed (MIPs) per second (sec) off-chip processor could execute only 15-20 million instructions of an algorithm in one second, in other words, instructions would be executed at a speed slower than the rated speed of the processor, because the off-chip processor would often have to execute one or more wait states before receiving new data for processing. Consequently, the 33 MIPs/sec off-chip processor could not execute the typically more complex algorithms associated with compressing voice information data which required that processing on one voice data frame be completed in the frame time, where the frame of data information is typically 125 microseconds long.

According to the present invention, a suitable processor, such as a 33 MIPs/sec processor, may be integrated on the chip 40 as the DSP 220 for executing instructions of an algorithm to process data and write data to and read data from the DRAM 210 at the rated speed of the processor without performing wait states as part of the process steps of a compression algorithm. For instance, the DSP 220 may transmit 16 data bits over 16 interfacing bus lines for accessing the data in the memory cells in a 2 to 4 MB DRAM 210 at the maximum operating speed of the DSP 220. The total time for the DSP 220 to access the contents of that 2 to 4 MB DRAM 210 would be approximately equal to 30 ns because: 10 ns is required for the DSP 220 to set up an address to be accessed, approximately 10 ns is required to access the address in the DRAM 210 using fast page mode access and approximately 10 ns is required to transmit the contents of the accessed address to the DSP 220. As compared to the prior art, approximately 10 wait states were required during data access by the off-chip processor, such that a complex algorithm for processing and storing data could not be performed.

Furthermore, the integration of the DSP 220 and the DRAM 210 on the same chip 40 places the DSP 220 and the DRAM 210 components in closer physical proximity than in prior art applications. This proximity, in turn, decreases the path length involved in data transfer as compared to that associated with off-chip communication. Consequently, the potential speed of access to the memory locations of the DRAM 210 by the DSP 220 further increases.

Returning to FIG. 1, in an alternative embodiment or the present invention, a plurality of interfacing connections $225_{1,2...x}$ may be created on the chip 40 between the DSP 220 and the component 230 by direct connections in a pitch matched fashion as described in Hsich & Chang and Stenstrorm & Mattheyes, supra. Direct connections between the circuit elements in the DSP 220 and the component 230 are possible because of the relatively small number or interconnections, typically on the order of 2 or 4, which are usually formed between the DSP 220 and an analog or digital functional component which may be implemented on the chip 40.

In a further embodiment of the present invention, resistive and capacitive structures may be fabricated within the component 230 during the fabrication of the DRAM 210 on the chip 40 in any of a variety of design applications, such as, for example, a voltage divider. Alternatively, these structures may be fabricated on other regions of the chip for other similarly suitable applications. In some applications, these structures may be used in the creation of functional components, such as, for example, analog-to-digital and digital-to-analog converters, which may be found in devices such as a telephone line interface, a microphone, a pre-amplifier, and a speaker amplifier. The integration of the above components on the same chip 40 which includes the DSP 220 and DRAM 210 according to the present invention may provide a cost effective, single chip system solution for a DRAM application, such as, for example, voice data storage in an answering machine.

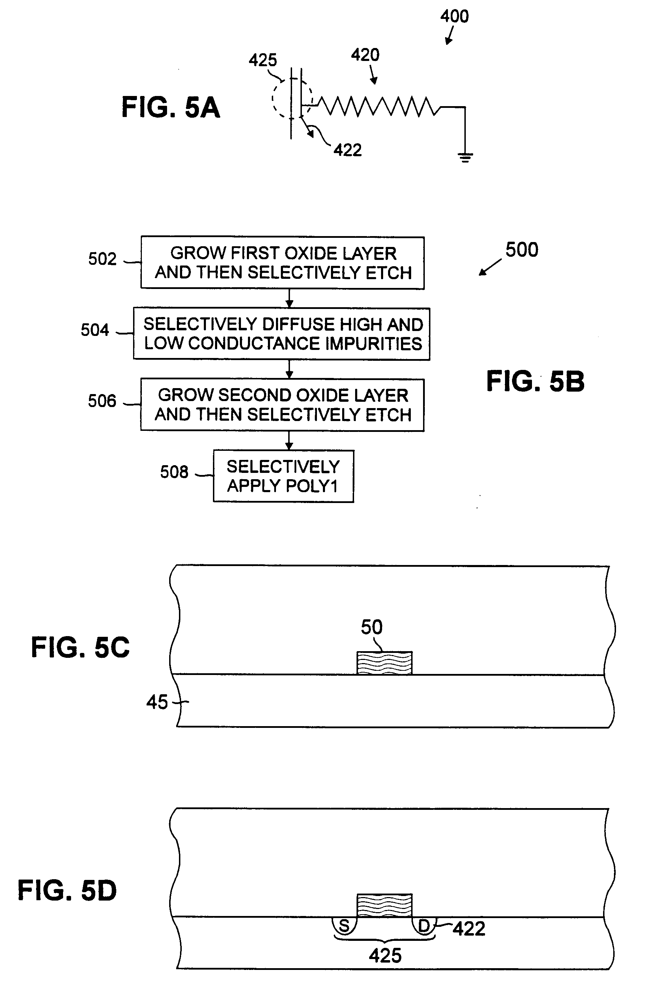

FIG. 5A shows an exemplary circuit 400 illustrating a suitable use of a resistor 420 which may be fabricated according to the present invention on a region of the chip 40 simultaneously during DRAM integration. The circuit 400 is designed to include a transistor 425, and the resistor 420 is connected to the drain 422 of the transistor 425 as a shunt to ground.

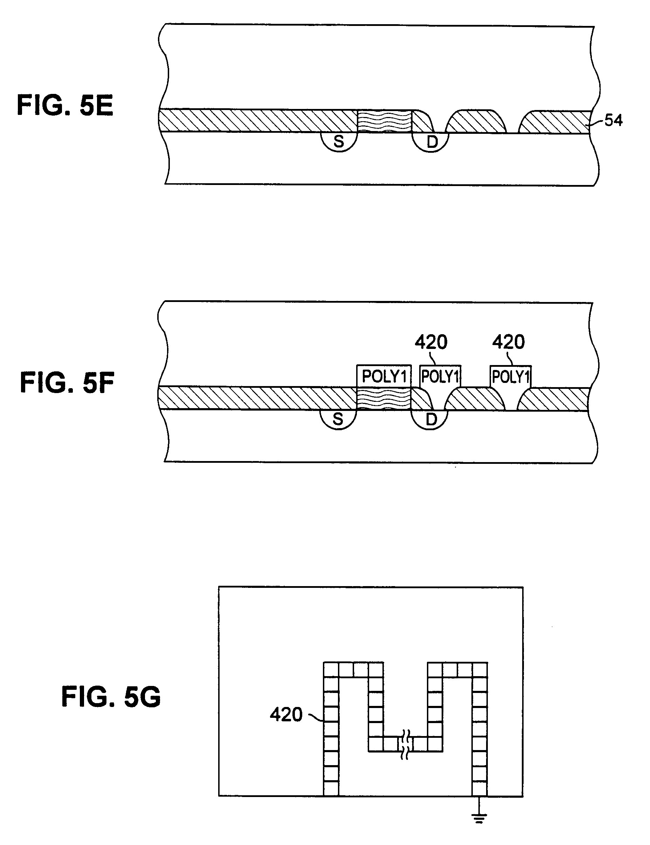

The resistor 420 may be formed according to the steps of a process 500, shown in FIG. 5B. The process 500 is described below with reference to FIGS. 5C-5F, which illustrate the various stages of the fabrication of the resistor 420. FIG. 5G shows an exemplary two-dimensional, top view of an implementation of the resistor 420 on the chip 40. The process 500 is described below with reference to steps that may be performed simultaneously with integrating a DRAM on the chip 40 according to the steps of the process 300, and with reference to additional steps which are specifically associated with the fabrication of a resistive structure according to the present invention. The materials used in the process 500 which are referred to above in the description of the process 300 are referred to below in the description of the process 500 using identical reference numerals.

In step 502, the first oxide layer 50 is grown on the substrate 45 and then selectively etched, as shown in FIG. 5C. Then, in step 504 impurities are selectively diffused to form a source region and a drain 422 region of the transistor 425, as shown in FIG. 5D. Then, in step 306, the second oxide layer 54 is grown and then selectively etched, as shown in FIG. 5E. The processing steps 502, 504 and 506 are preferably performed in a similar fashion and at the same time as steps 302, 304 and 306 of the process 300, respectively, according to the techniques of this invention.

Then, in step 508, the POLY1 layer is selectively applied as a strip on the chip 40 to form the gate of the transistor 425 and, simultaneously, the resistor 420, as shown in FIG. 5F. Note, the step 508 may be performed concurrently with the step 308 of the process 300 according to this invention.

FIG. 5G shows an exemplary layout of the strip of the POLY1 which is used to form the resistor 420 on the chip 40 in step 508. The strip of the POLY1 layer may be applied on the chip 40 in any suitable manner that conserves physical area, such as the serpentine pattern shown in FIG. 5G. Referring to both FIGS. 5F and 5G, one end of the strip of the POLY1 forms a contact to the drain 422 of the transistor 425 and the other end of the strip is displaced away from the drain 422 contact and forms a contact to the substrate 45.

By way of example, the selective deposition of the POLY1 layer as a strip to form the resistor 420 may be described in terms of the selective deposition of a plurality of interconnected squares of material, as shown in FIG. 5G. The total number of squares in the strip defines the resistive value, R, of the resistor 420 according to the equation $R = n\rho$, where $\rho$ is the resistivity of the selectively applied layer of material in ohms/square and n is the number of squares which are included in the length of the selectively applied strip. For instance, the resistivity of the undoped polysilicon used in DRAM processing is on the order of 50 ohms/square, whereas the highly doped materials or metal layers which are used to form resistors in a standard digital processes typically have a resistivity on the order of 3 ohms/square.

The inventive technique fulfills a need for a local routing means on a chip which reduces chip size. The high resistivity characteristics of the POLY1 layer, which is used to form the DRAM transistor interconnects and DRAM transistor gate regions during DRAM fabrication, are advantageously exploited according to this invention for creating the resistive structure 420 on the chip 40. A resistor, therefore, may be formed from the polysilicon material which is available during DRAM processing on less physical chip area of a semiconductor chip than that required if the materials associated with standard digital processing techniques were utilized

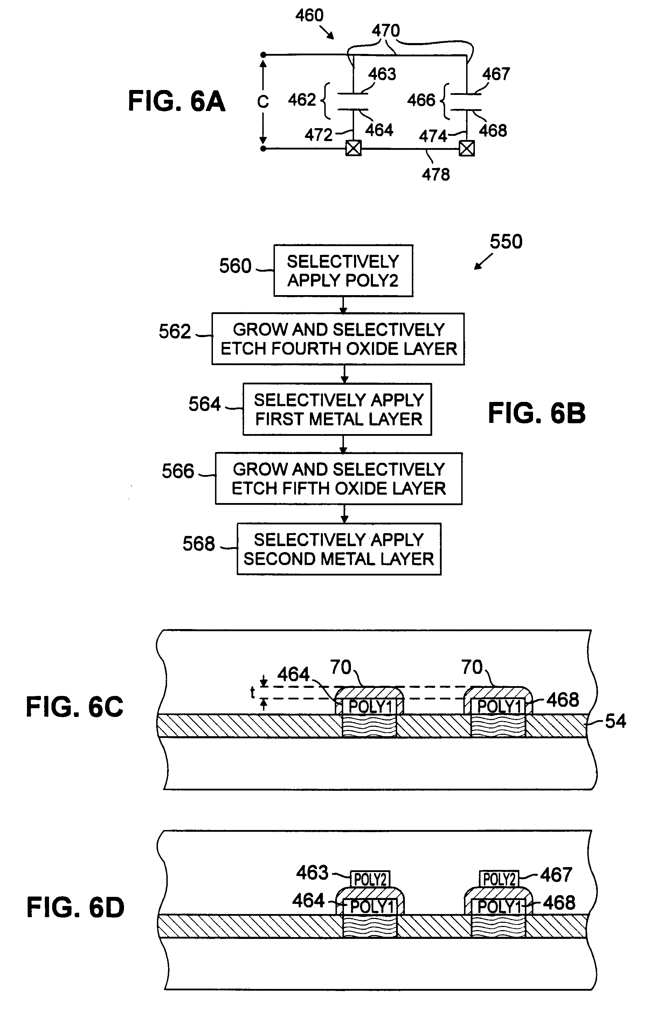

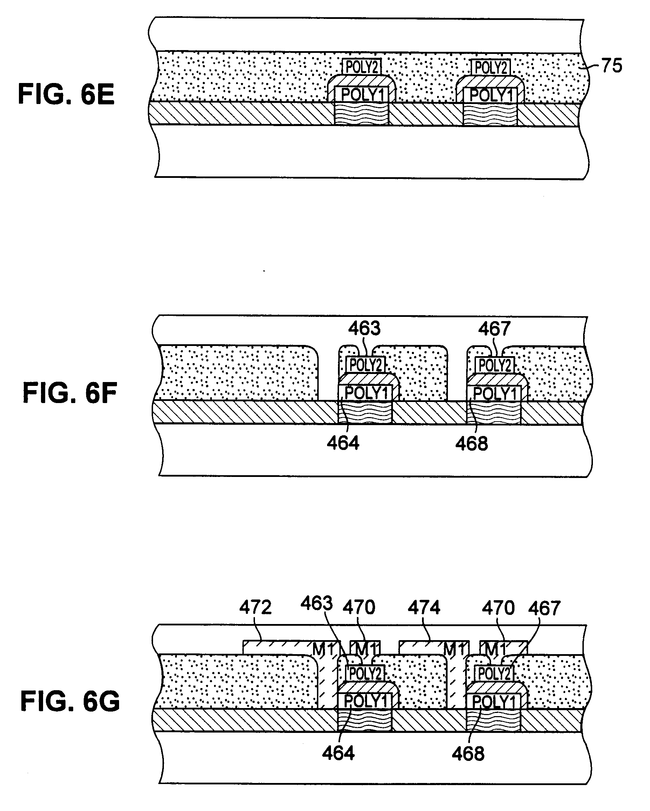

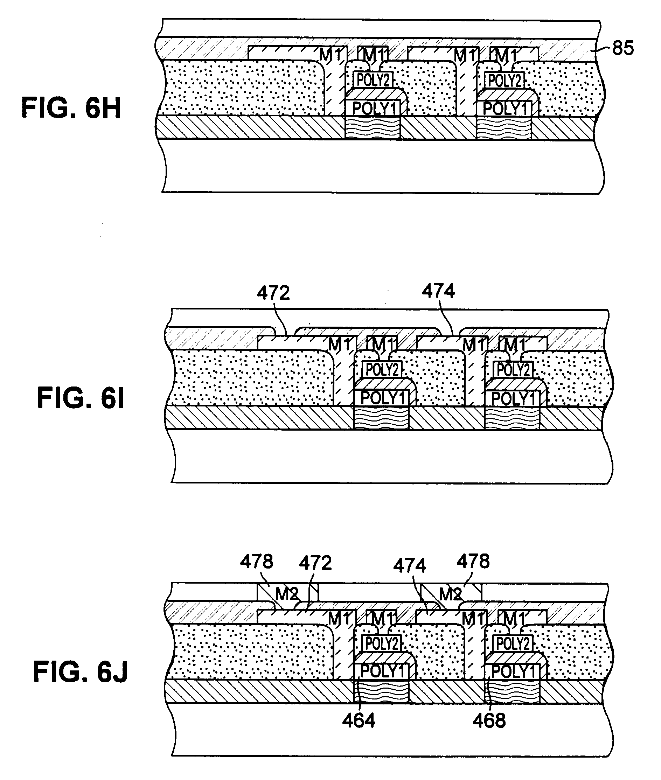

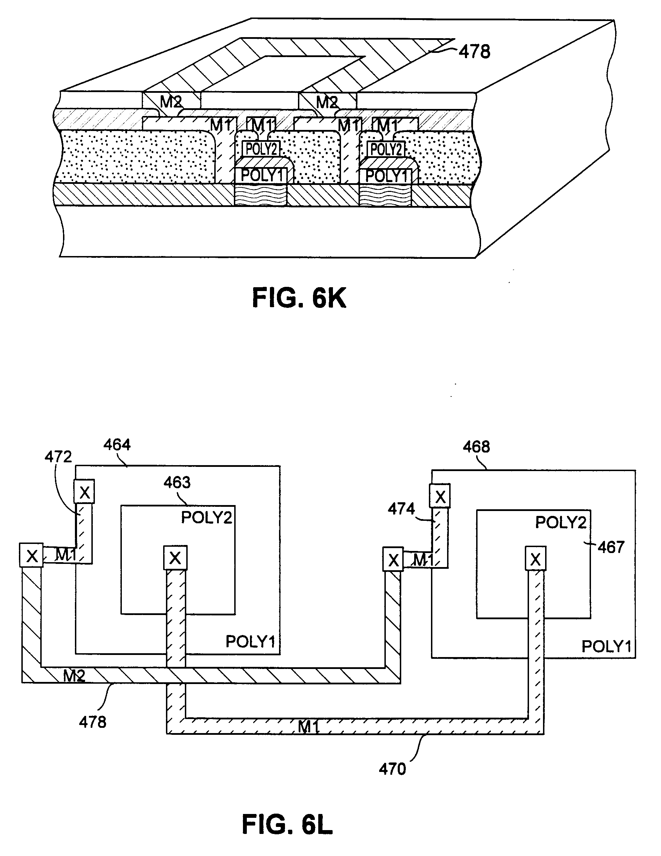

FIG. 6A shows an exemplary embodiment of a capacitive structure 460, having a capacitance C, which may fabricated as part of the component 230 on the chip 40 according to the present invention, and is typical of that structure which is found in a switched analog-to-digital converter. It is known that the capacitive values of the memory cell capacitors which are typically formed on a DRAM chip from layers of metal in accordance with digital processing techniques may vary significantly in response to slight changes in voltage and temperature. Also, a capacitor fabricated using layers of metal consumes more chip area than that formed using the materials associated with DRAM processing because the thickness of an oxide formed between layers of metals is higher than that formed between layers of polysilicon using present techniques. Further, an oxide layer formed between layers of metal is of lower quality in terms of the uniformity of the oxide. The present invention overcomes these disadvantages because the capacitor formed using layers of polysilicon is smaller and more uniform.

The capacitor 460 includes two symmetrically balanced capacitive regions 462 and 466, which are formed and connected in the manner explained below. The capacitive region 462 is comprised of capacitive plates 463 and 464, and the capacitive region 466 is comprised of capacitive plates 467 and 468.

A metal interconnect 470 connects plates 463 and 467. A metal interconnect 472 is in contact at one end with plate 464, and a metal interconnect 474 is in contact at one end with the plate 468. A metal interconnect 478 connects the other ends of the metal interconnects 474 and 472, such that the plate 468 is electrically connected to the plate 464.

The fabrication of the capacitor 460 on the chip 40 according to the present invention is described below with respect to a process 550, as shown in FIG. 6B, and FIGS. 6C to 6J, which show various stages of the fabrication of the capacitive structure 460. FIG. 6K shows a three-dimensional cross-sectional view of the capacitor 460 on the chip 40. FIG. 6L shows a diagrammatic layout of the first and second metal layers and the first and second polysilicon layers which are used to form the components and connections of the capacitor 460.

The materials used in the process 550 which are referred to above as part of the description of the processes 300 and 500 are referred to below in the description of the process 550 using identical reference numbers. The process 300 is referred to below to explain various stages of the process 550, and to highlight the advantages of fabricating the capacitor 460 according to the present invention during DRAM integration.

FIG. 6C shows the results of the performance of the steps 302 through 310 of the process 300 on a portion of the chip 40 designated for the fabrication of a capacitive structure 460. The capacitive plates 464 and 468 may be formed on the chip 40 from POLY1 selectively applied in step 300, where the plates 464 and 468 lie upon the oxide layer 50 selectively applied in step 302 and are bounded laterally by the oxide layer 54 which is selectively applied in step 306. Then, in step 310, the oxide layer 70 is selectively applied on the chip 40 at a thickness equal to $t$ on the plates 464 and 468.

It is noted that, in accordance with capacitor formation on a region of the chip 40, impurities are not selectively applied in this region of the chip 40 pursuant to step 304. After step 310, the step 560 of the process 550 may be performed.

Referring to FIG. 6B, in step 560, a second polysilicon layer (POLY2) is selectively applied on the chip 40 to form the plates 463 and 467 over the plates 464 and 468, as shown in FIG. 6D. Referring to the process 300, step 560 is preferably performed after step 310 and before step 316 in order to allow for simultaneous fabrication of components to occur in different portions of the chip 40. Step 562 is then performed.

In step 562, the oxide layer 75 is grown and then selectively etched, as shown in FIGS. 6F and 6F, to expose a portion of each of the capacitive plates 464, 463, 467 and 468. Step 562 preferably corresponds to step 316 of the process 300.

In step 564, the M1 layer is selectively applied on the chip 40, as shown in FIG. 6G, to form the first metal interconnect 470, which places the plate 467 in contact with the plate 463. The interconnect 470 is applied on the chip 40 using well known techniques to connect the plate 467 to the plate 463 as shown illustratively in FIG. 6L. Further, the M1 layer is also selectively applied in step 564 to form the second and third metal interconnects 472 and 474, which contact the exposed regions of the plates 464 and 468, respectively, as shown in FIGS. 6G and 6L.

In step 566, a fifth layer of oxide 85 is grown on the chip 40, and then selectively etched to expose regions of the metal interconnects 472 and 474, as shown in FIGS. 6H and 6I. Step 566 is preferably performed before the second metal layer M1 is selectively applied to the chip 40 in accordance with the present invention. For example, assuming that the process 300 is being performed for fabricating interconnections between the DRAM 210 and DSP 220, step 566 would preferably be performed between the steps 316 and 318 of the process 300.

In step 568, the M2 layer is selectively applied to the chip 40 to form the metal interconnect 478. The interconnect 478 suitably connects the plates 464 and 468 via the first metal interconnects 472 and 474, as shown in FIGS. 6J, 6K and 6L.

The thickness of the separation, $t$, between the capacitive plates 464 and 463, and 468 and 467, which are formed from the first and second polysilicon layers, respectively, defines the capacitance C of the capacitor 460. Further, the use of two capacitive regions to form the capacitor 460 is a standard technique of matching geometric regions and well known in the art of DRAM processing. DRAM fabrication techniques, thus, are exploited by the inventive technique to allow for the formation of a capacitive structure 460 which includes capacitive plates that are connected in an advantageous manner by the selective application of the M2 layer ordinarily used during DRAM processing steps.

It is to be understood that the embodiments and variations shown and described above are illustrative of the principles of this invention only and that various modifications may be implemented by those skilled in the art without departing from the scope of the invention.

**Claims**

1.  A method for fabricating interfacing connections between a digital random access memory (DRAM) that is integrated on a first region of a semiconductor chip and a functional component that is simultaneously integrated on a second region of the chip during DRAM fabrication, comprising the steps of:

    (A) selectively diffusing low conductivity impurities in the first region of the chip for forming transistors in the DRAM;

(B) selectively applying a first and second polysilicon layer and a first metal layer in the first region of the chip to form circuit elements in the DRAM; and,

(C) selectively applying the first metal layer and a second metal layer on the chip during DRAM fabrication to create interfacing interconnections between the DRAM and the functional component.

2. The method of claim 1, wherein the functional component fabricated on the second region of the chip is a processor, and wherein the method of fabricating the processor sinultaneously during DRAM fabrication further comprises the steps of:

(D) selectively diffusing high conductivity impurities for forming transistors in the second region of the chip simultaneously during the performance of Step (A); and,

(E) selectively applying the first and second polysilicon layer and the first metal layer in the second region of the chip to form circuit elements in the processor simultaneously during the performance of step (B).

3. The method of claim 2, wherein a resistive structure is fabricated on a third region of the chip simultaneously during the fabrication of the DRAM and the processor, the method further comprising the step of:

(F) selectively applying the first polysilicon layer as a strip to the third region of the chip simultaneously during the performance of step (B), such that the resistor, processor and DRAM are all simultaneously integrated on the chip.

4. The method of claim 2, wherein a capacitive structure is fabricated on a third region of the chip simultaneously during the fabrication of the DRAM and the processor, the method further comprising the steps of:

(F) selectively applying the first polysilicon layer to form first and second capacitive plates;

(G) selectively applying an oxide layer over the first and second capacitive plates;

(H) selectively applying the second polysilicon layer to form third and fourth second capacitive plates over the first and second capacitive plates, wherein the first and third and second and fourth capacitive plates are separated, respectively, by the oxide layer;

(I) selectively applying the first metal layer to create a first metal interconnect connecting the second and fourth capacitive plates and to create second and third metal interconnects which are in contact with the first and third capacitive plates, respectively; and,

(J) selectively applying the second metal layer to create a fourth metal interconnect that connects the second and third metal interconnects, such that a common connection is formed between the first and third capacitive plates,

and wherein steps (F) through (J) are performed simultaneously during the performance of step (B), such that the capacitor, processor and DRAM are all simultaneously integrated on the chip.

5. The method of claim 2, wherein an analog functional component is fabricated on a third region of the chip simultaneously during the performance of steps (A) through (B).

6. The method of claim 5, wherein the analog functional component further comprises a resistor, wherein the resistor is formed by the selective application of the first polysilicon layer on the third region of the chip simultaneously during the performance of step (B).

7. The method of claim 6, wherein the analog functional component is connected to the DRAM by the selective application of the second metal layer on the chip during step (C).

8. The method of claim 5, wherein the analog functional component further comprises a capacitor, wherein the capacitor is formed by the selective application of the first and second polysilicon layers and the first and second metal layers on the third region of the chip simultaneously during the performance of steps (B) through (C).

9. The method of claim 2, wherein a digital functional component is fabricated on a third region of the chip simultaneously during the performance of steps (A) through (B).

10. The method of claim 2, wherein the processor is a digital signal processor.

11. The method of claim 2, wherein the first metal layer is selectively applied for creating DRAM signal stubs contacting circuit elements in the DRAM and for creating processor signal stubs contacting circuit elements in the processor, and wherein the second metal layer is selectively applied in a metal routing region on the chip for creating interconnects which connect respective DRAM signal stubs to DSP signal stubs for establishing an interface between the processor and the DRAM on the chip.

12. A method for fabricating a capacitive structure on a first region of a semiconductor chip simultaneously during the fabrication of a DRAM on a second region of the chip, comprising the steps of:

selectively diffusing low conductivity impurities and selectively applying a first metal layer and a first and second polysilicon layer to form the DRAM on the first region of the chip;

simultaneously, during DRAM fabrication, on a second region of the chip,

selectively applying the first polysilicon layer to form first and second capacitive plates,

selectively applying an oxide layer over the first and second capacitive plates,

selectively applying the second polysilicon layer to form third and fourth second capacitive plates over the first and second capacitive plates, wherein the first and third and second and fourth capacitive plates are separated, respectively, by the oxide layer,

selectively applying the first metal layer to create a first metal interconnect connecting the second and fourth capacitive plates and to create second and third metal interconnects which are in contact to the first and third capacitive plates, respectively, and,

selectively applying a second metal layer to create a fourth metal interconnect that connects the second and third metal interconnects, such that a common connection is formed between the first and third capacitive plates.

13. A semiconductor chip comprising:

an integrated DRAM for storing data; and,

a processor simultaneously fabricated on the chip and connected to the DRAM using bus lines fabricated during the integration of the DRAM, wherein the DRAM and the processor are fabricated from high and low conductivity impurities, respectively, and selectively applied first and second polysilicon layers and a selectively applied first metal layer, and

wherein the bus lines are formed from the selective application of a second metal layer, such that the number of bus lines fabricated enable the processor to read data from and write data to the DRAM.

14. The chip of claim 13, wherein a portion of the DRAM is utilized as a scratch pad memory by the processor during processing of data written to an read from the DRAM by the processor.

15. The chip of claim 13, further comprising a resistor simultaneously fabricated on the chip from polysilicon material during DRAM and processor integration.

16. The chip of claim 13, further comprising a capacitor simultaneously fabricated on the chip from first and second polysilicon layers and first and second metal layers during DRAM and processor integration.

17. The chip of claim 13 further comprising:

a functional component fabricated simultaneously during the integration of the DRAM on the chip for processing data that may be provided from the DRAM and the processor.

18. The chip of claim 17, wherein the component is an analog device.

19. The chip of claim 17, wherein the component is a digital device.

20. A method for fabricating a resistive structure on a first region of a semiconductor chip simultaneously during the fabrication of a DRAM on a second region of the chip, comprising the steps of:

selectively diffusing low conductivity impurities and selectively applying a first and second polysilicon layer and a first metal layer to form the DRAM on the second region of the chip, and simultaneously selectively applying the first polysilicon layer as a strip to the first region of the chip, such that the strip of the first polysilicon layer may be used on the chip as a resistive structure.

21. The method of claim 20, wherein the resistive structure is fabricated as part of a functional component that is fabricated on the first region of the chip simultaneously during DRAM integration on the second region of the chip.

22. The method of claim 21, wherein the functional component is a processor.

23. The method of claim 21, wherein the functional component is an analog to digital converter.

24. A capacitive structure formed on a first region of a semicondcutor chip simultaneously during the fabrication of a DRAM on a second region of the chip, wherein the DRAM is fabricated by selectively diffusing low conductivity impurities and selectively applying a first and second polysilicon layer and a first metal layer on the second region of the chip, the capacitive structure comprising:

first capacitive plates formed from the selective application of the first polysilicon layer to the first region of the chip;

second capacitive plates formed from the selective application of the second polysilicon layer to the first region of the chip, where the second capacitive plates overlie the first capacitive plates;

first metal interconnects formed from the selective application of the first metal layer to the first region of the chip, wherein the first metal interconnects connect a pair of second capacitive plates; and,

a second metal interconnect formed from the selective application of a second metal layer to the first region of the chip, wherein the second metal interconnect connects a pair of first capacitive plates which underlie the pair of second capacitive plates that are interconnected by the first metal interconnects.

25. A method for simultaneously fabricating a digital random access memory (DRAM) on a first region of a semiconductor chip and a processor on a second region of the chip, comprising the steps of:

(A) applying a first oxide layer on the entire chip, and then selectively etching the first oxide layer in the first and second regions of the chip;
(B) selectively diffusing low conductivity impurities in the first region of the chip for forming transistors in the DRAM while selectively diffusing high conductivity impurities in the second region of the chip for forming transistors in the processor;
(C) selectively applying a second oxide layer in the first and second regions of the chip; and,
(D) selectively applying a first polysilicon layer in the first and second regions of the chip.

26. A method for simultaneously fabricating a digital random access memory (DRAM) on a first region of a semiconductor chip and a resistor on a second region of the chip, comprising the steps of:

(A) applying a first oxide layer on the entire chip, and then selectively etching the first oxide layer in the first and second regions of the chip;
(B) selectively diffusing low conductivity impurities in the first region of the chip for forming transistors in the DRAM;
(C) selectively applying a second oxide layer in the first region of the chip; and;
(D) selectively applying a first polysilicon layer in the first and second regions of the chip, wherein the first polysilicon layer is selectively applied in the first region to form gates of the DRAM transistors and wherein the first polysilicon layer is applied as a strip in the second region to form the resistor on the chip.

27. The method of claim 25 or 26, further comprising the steps of:

(E) selectively applying a third oxide layer in the first and second regions of the chip;
(F) selectively etching the third oxide layer in the first region of the chip and the second oxide layer in the second region of the chip;

(G) selectively applying a first metal layer in the first and second regions of the chip to create contacts to the DRAM and the processor, or resistor respectively;
(H) applying a fourth oxide layer on the entire chip, and then selectively etching the fourth oxide layer in the first region to expose DRAM contacts while simultaneously selectively etching the fourth oxide layer in the second region to expose processor, or resistor contacts; and,
(I) selectively applying a second metal layer in the first and second regions of the chip to create interconnections between the DRAM contacts and the processor or resistor contacts.

**FIG. 1**

FIG. 2

FIG. 3A

300

302 — GROW FIRST OXIDE LAYER AND THEN SELECTIVELY ETCH

304 — SELECTIVELY DIFFUSE HIGH AND LOW CONDUCTANCE IMPURITIES

306 — SELECTIVELY GROW SECOND OXIDE LAYER

308 — SELECTIVELY APPLY POLY1 LAYER

310 — SELECTIVELY GROW THIRD OXIDE LAYER

312 — SELECTIVELY ETCH SECOND OXIDE LAYER IN DSP REGION AND THIRD OXIDE LAYER IN DRAM REGION

314 — SELECTIVELY APPLY FIRST METAL LAYER

316 — GROW FOURTH OXIDE LAYER AND THEN SELECTIVELY ETCH

318 — SELECTIVELY APPLY SECOND METAL LAYER

**FIG. 3B**

**FIG. 4A**

50    50

45

**FIG. 4B**

A ———————————————————————— A

S    D    S    D

14    18

**FIG. 4D**

A ———————————————————————— A

50    50

54

S    D    S    D

14    18

**FIG. 4F**

A ———————————————————————— A

POLY 1    POLY 1

S    D    S    D

14    18

**FIG. 4C**

**FIG. 4E**

**FIG. 4G**

17

EP 0 718 888 A2

FIG. 4H

70        70

POLY1    POLY1

S      D   S      D

14        18

FIG. 4J

POLY1    POLY1

S      D   S      D          —54

14        18

FIG. 4L

$60_1$

M1  POLY1   M1  POLY1  M1

S      D   S      D

14        18

FIG. 4I

FIG. 4K

FIG. 4M

**FIG. 4N**

A — — — — — — — — — — — — — — — — — — A

75

M1  POLY1  M1  POLY1  M1
S        D    S        D
14            18

**FIG. 4O**

B — — — — — — — — — — — — — — — — — — B

75

M1  POLY1  M1  POLY1
S        D    S        D
24            28

**FIG. 4P**

100

A — — — — — — — — — — — — — — — — — — A

75

M1  POLY1  M1  POLY1  M1
S        D    S        D
14            18

**FIG. 4Q**

120

B — — — — — — — — — — — — — — — — — — B

75                                    75

M1  POLY1  M1  POLY1
S        D    S        D
24            28

A — — — — — — — — — — — — — — — — — — — — — — — — — — A

110₁

M2

**FIG. 4R**

M1 POLY1 M1 POLY1 M1

S D S D

14 18

B — — — — — — — — — — — — — — — — — — — — — — — — — — B

110₁

M2

**FIG. 4S**

65₁

M1 M1 POLY1 POLY1

S D S D

24 28

B — — — — — — — — — — — — — — — — — — — — — — — — — — B

110₁

M2

A — — — — — — — — — — — — — — — — — — — — — — — — A

M1 POLY1 M1 POLY1 M1

S D S D

14 18

**FIG. 4T**

**400**

**425**

**420**

**FIG. 5A**

**422**

---

502 — GROW FIRST OXIDE LAYER AND THEN SELECTIVELY ETCH

**500**

504 — SELECTIVELY DIFFUSE HIGH AND LOW CONDUCTANCE IMPURITIES

506 — GROW SECOND OXIDE LAYER AND THEN SELECTIVELY ETCH

**FIG. 5B**

508 — SELECTIVELY APPLY POLY1

---

**FIG. 5C**

**50**

**45**

---

**FIG. 5D**

S    D — **422**

**425**

**FIG. 5E**

**FIG. 5F**

420   420

POLY1  POLY1   POLY1

**FIG. 5G**

420

**FIG. 6A**

460

470

463

467

462 {  466 {

C

472  464  474  468

478

**FIG. 6B**

560 — SELECTIVELY APPLY POLY2

550

562 — GROW AND SELECTIVELY ETCH FOURTH OXIDE LAYER

564 — SELECTIVELY APPLY FIRST METAL LAYER

566 — GROW AND SELECTIVELY ETCH FIFTH OXIDE LAYER

568 — SELECTIVELY APPLY SECOND METAL LAYER

**FIG. 6C**

464  70  70

t  POLY1  POLY1  468

54

**FIG. 6D**

463 — POLY2  POLY2 — 467

464 — POLY1  POLY1 — 468

**FIG. 6E**

**FIG. 6F**

**FIG. 6G**

**FIG. 6H**

**FIG. 6I**

472       474

**FIG. 6J**

478   472     474   478

464      468

478

M2  M2
M1  M1  M1  M1
POLY2  POLY2
POLY1  POLY1

**FIG. 6K**

472
464
463
POLY2
X
X  M1
X
POLY1

468
474
X
POLY2
467
X  M1
X
POLY1

M2
478
M1
470

**FIG. 6L**